# EUROPEAN PATENT SPECIFICATION

(11) **EP 1 401 013 B1**
(45) Date of publication and mention of the grant of the patent: **04.04.2012**
(21) Application number: 02730839.4
(22) Date of filing: 31.05.2002
(51) Int. Cl.: H01J 37/32, C23C 16/458, C23C 14/50

(54) **PLASMA PROCESSING DEVICE**
PLASMAVERARBEITUNGSEINRICHTUNG
DISPOSITIF DE TRAITEMENT DE PLASMA

(30) Priority: 01.06.2001 JP 2001167329; 20.12.2001 JP 2001388134; 14.05.2002 JP 2002138851
(43) Date of publication of application: 24.03.2004
(73) Proprietor: TOKYO ELECTRON LIMITED, Tokyo 107-8481 (JP)
(72) Inventor: IKEDA, Taro c/o Tokyo Electron AT Limited, Nirasaki-shi, Yamanashi 407-0192 (JP); IIZUKA, Hachishiro c/o Tokyo Electron AT Limited, Nirasaki-shi, Yamanashi 407-0192 (JP); YAMAMOTO, Kaoru c/o Tokyo Electron AT Limited, Nirasaki-shi, Yamanashi 407-0192 (JP)
(74) Representative: Liesegang, Eva
(86) International application number: PCT/JP2002/005367
(87) International publication number: WO 2002/099863

(56) References cited:
- EP-A- 0 795 626
- EP-A- 1 063 690
- WO-A-99/03132
- DE-A- 19 943 053
- JP-A- 7 135 200
- JP-A- 8 181 124
- JP-A- 10 102 235
- US-B1- 6 178 918

## Description

### Field of the Invention

The present invention relates to a plasma processing unit and a plasma processing method. In particular, the present invention relates to a plasma processing unit and a plasma processing method wherein an efficient initialization of the plasma processing unit is achieved.

### Background Art

In recent years, a semiconductor device has been manufactured with an increased density and a higher integration, which makes a design rule thereof severer. For example, a line width of a gate wiring pattern or the like becomes narrower, and an aspect ratio of a contact hole, which is a connection part between a semiconductor device as a lower layer and a wiring layer as an upper layer, becomes higher.

In manufacturing a semiconductor device which has been designed according to the severe design rule, it is important to control the manufacturing process. For example, in an etching step, a contact hole having a fine pattern and/or a high aspect ratio must be exactly etched. Thus, it is necessary to control an etching rate to securely form a desired pattern.

However, in a plasma processing unit for carrying out an etching process, particularly in a plasma processing unit for carrying out an etching process by using an inductively coupled plasma (hereinafter referred to as "ICP"), since an electrical potential is not applied to a chamber made of, e.g. quartz, etched substances tend to be deposited on an inner wall or the like of the chamber as extraneous material. The extraneous material deposited on the inner wall or the like of the chamber may have an impact on a plasma condition when an etching process is conducted, so that an etching rate may be fluctuated.

According to various needs accompanied with a progress of semiconductor device, many kinds of processes can be executed. To give an example, before a material such as tungsten is embedded in a contact hole, an oxide film (SiO₂, for example) must be etched which has been formed by an oxidation or modification at a bottom of the contact hole. However, when etching a conductive material other than the oxide film to be etched, such as Poly-Si, W, WSi, CoSi and so on, if etching the oxide film again thereafter, a phenomenon so-called memory effect may be caused.

A memory effect is as follows: When a film made of a metal such as CoSi is etched, etched substances are deposited in a chamber of quartz or on an inner wall thereof. Then, electrons, ions or the like generated in a plasma are grounded via the deposited substances, and thus the plasma becomes unstable. Even when an oxide film as a target is etched immediately thereafter under the same condition, a steady etching rate cannot be obtained because the plasma is unstable. This phenomenon is called memory effect. That is, when etching a film other than films to be generally etched, substances different from those generally deposited in the chamber or on the inner wall are deposited therein or thereon. This causes a change of impedance with respect to the plasma, so that the plasma condition is affected to generate a memory effect.

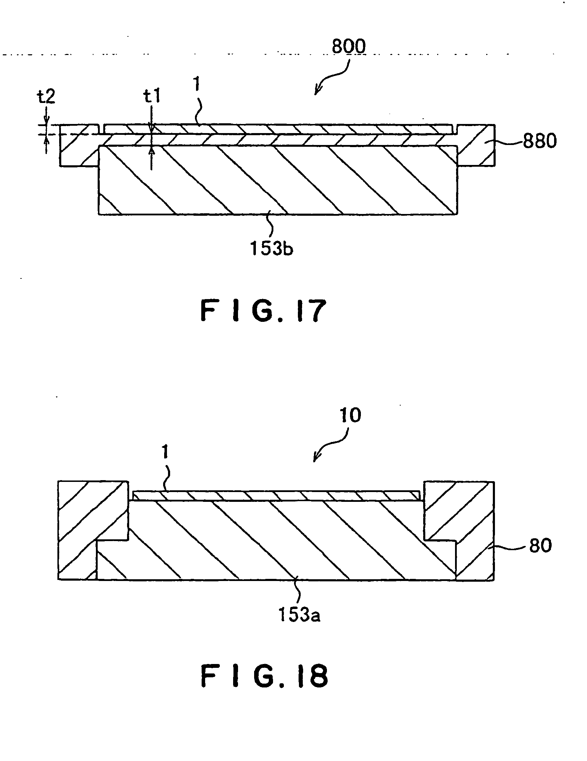

Fig. 18 is a schematic cross-sectional view showing an example of a semiconductor-wafer stage 10 in a conventional plasma processing unit. As shown in Fig. 18, the semiconductor-wafer stage 10 includes a guide ring 80 and a susceptor 153.

The susceptor 153 is made of, for example, AlN. The guide ring 80 is made of, for example, quartz material such as SiO₂. The guide ring 80 surrounds an outer periphery of the susceptor 153. An upper surface of the guide ring 80 is positioned higher than the susceptor 153. This allows for the guide ring 80 to guide an outer periphery of a semiconductor wafer 1 in a precise location.

An etching process of a semiconductor wafer of an SiO₂ film is generally carried out by using a plasma processing unit including such a semiconductor-wafer stage 10. In the course of the etching process, when a surface of a semiconductor wafer covered with a Poly-Si film is etched, and then a wafer having a surface of the SiO₂ film is etched again, the etching rate is lowered. In this case, in order to recover a general etching rate, five pieces of semiconductor wafers of an SiO₂ film, for example, must be etched (which corresponds to, e.g., 150 seconds as an etching period).

The reason is considered as follows: since Si of Poly-Si is dispersed and deposited on an inner wall surface of a chamber, a plasma condition is once degraded. However, when several pieces of semiconductor wafers of an SiO₂ film are etched, oxide is deposited again in the chamber to some degree, so that the plasma condition is recovered to the original steady one.

Thus, dummy wafers are etched so as to recover the etching rate to the steady one. However, the use of dummy wafers needs increased time, cost, and man power, which is disadvantageous in productivity and working efficiency.

The substances deposited on the inner wall of the chamber can be cleaned by using a ClF₃ gas so as to be etched (eliminated). However, such an etching process is difficult to carry out. Further, in order that the unit is recovered to the steady state after the etching process (elimination), certain pieces of dummy wafers must be etched in the end.

When a plurality of semiconductor wafers are etched, since an operating time of the unit is prolonged, substances deposited on the inner wall of the chamber are thickened. Thus, the deposited substances are peeled off by means of internal stresses thereof, or an outer stress, which is caused by reduction and/or corrosion of the substances by ions and radicals in a process gas. Therefore, there may be generated particles.

It has been found that generation of the particles can be restrained by plasma-treating a wafer with a surface covered with an oxide film as a dummy wafer to deposit an oxide on the inner wall of the chamber. However, this operation is also disadvantageous in productivity and working efficiency.

The guide ring 80 surrounding the susceptor 153 is constituted such that the upper surface thereof is positioned higher than the susceptor 153. This constitution provokes an unstable plasma around a wafer. To be specific, this constitution brings a spoiled in-plane uniformity of a plasma treatment such as a film-forming process and an etching process.

An O-ring, and a flat-type or L-type gasket with plane surfaces are conventionally used for sealing between a dielectric wall, specifically a dielectric wall of a bell-jar type, and (other walls of) a treatment chamber.

When an O-ring is used, it is necessary to protect parts other than a contact surface of the O-ring, against breakage. On the other hand, when a flat-type or L-type gasket is used, a disadvantage arises that a vacuum leakage tends to be generated because a sufficient surface pressure to a sealing surface cannot be secured.

In addition, in order to introduce a process gas to a treatment chamber, a constitution wherein a plurality of gas inlet holes are formed in a ceiling portion, that is, a so-called showerhead constitution is conventionally employed.

However, in the showerhead constitution, a gap between a wafer and the gas inlet holes is limited according to a structure of the processing unit, and the gas is not uniformly distributed around an outer periphery of the wafer. Thus, there is a disadvantage in that an in-plane uniformity of a plasma treatment such as a film-forming process and an etching process is spoiled.

A plasma processing unit with all the features of the preamble of claim 1 is disclosed in European patent application EP 0 795 626 A1.

### Summary of the Invention

An object of the present invention is to provide a plasma processing unit and a plasma processing method wherein the plasma processing unit can start to operate efficiently, an etching process of a material other than an oxide film can be suitably carried out, and generation of particles can be prevented.

Another object of the present invention is to provide a plasma processing unit capable of preventing metal contamination caused by a material composition of members, such as a stage and so on, which constitute the processing unit.

This invention is a plasma processing unit as defined in claim 1

Preferred embodiments are defined in dependent claims 2-7.

### Brief Description of the Drawings

Fig. 1 is a schematic view showing a plasma processing unit according to a first embodiment of the present invention;
Fig. 2 is a schematic sectional view showing a semiconductor-wafer placing portion according to the first embodiment of the present invention;
Fig. 3 is a schematic sectional view showing a structure of an upper portion of a bell jar;
Fig. 4 is an enlarged view of P portion of Fig. 3;
Fig. 5 is a plan view of a connecting part;
Fig. 6 is a schematic sectional view of a gas-introducing ring according to the first embodiment of the present invention;
Fig. 7 is a schematic sectional view of a gas-introducing ring according to another embodiment of the present invention;
Fig. 8 is a view showing a constitution of a gas way;
Fig. 9 is a sectional view of a gasket according to an embodiment of the present invention;
Fig. 10 is an abundance analysis chart by means of SEM-EDX (Scanning Electron Microscope with Energy Dispersive type of X-ray spectroscope);
Fig. 11 is a conceptual view of generation of particles;
Fig. 12 is a graph showing a change of etched amount caused by memory effect;
Fig. 13 is a graph showing a change of etched amount caused by memory effect;
Fig. 14 is a schematic sectional view showing a semiconductor-wafer placing portion according to an example helpful for understanding the present invention;
Fig. 15 is a schematic sectional view showing a semiconductor-wafer placing portion according to another example helpful for understanding the present invention;
Fig. 16 is a schematic sectional view showing a semiconductor-wafer placing portion according to another example helpful for understanding the present invention;
Fig. 17 is a schematic sectional view showing a semiconductor-wafer placing portion according to another example helpful for understanding the present invention; and
Fig. 18 is a schematic sectional view showing an example of a semiconductor-wafer placing portion in a conventional plasma processing unit.

### Description of the Preferred Embodiment

Hereinafter, with reference to the attached drawings, a plasma processing unit according to the present invention and preferable embodiments of an initializing step thereof are explained in detail. In the specification and the drawings, the same sign is given to substantially the same element, and duplication of explanation is omitted.

### (First Embodiment)

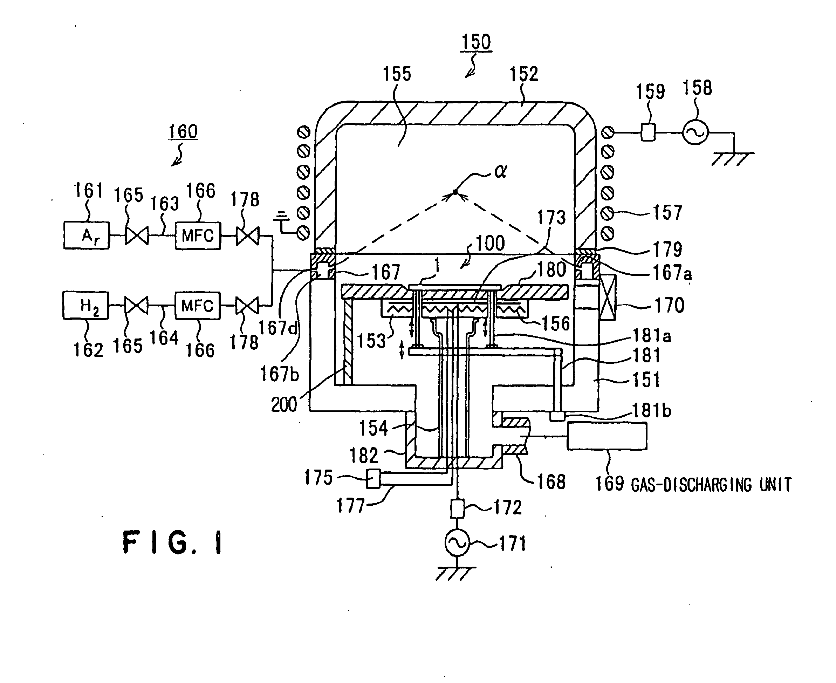

Fig. 1 is a schematic view showing a plasma processing unit according to the preferred embodiment of the present invention. As shown in Fig. 1, a plasma processing unit 150 is an etching unit to remove an oxide film on a semiconductor wafer, or another film made of any other material. An inductively coupled plasma (ICP) can be adopted.

The unit 150 has a chamber 151 of a substantially cylindrical shape and a bell jar 152 of a substantially cylindrical shape. The bell jar 152 is hermetically provided on the chamber 151 via a gasket 179, which is described below. The bell jar 152 is made of a dielectric material such as quartz or a ceramics material.

A susceptor 153 is provided in the chamber 151. The susceptor 153 is for horizontally supporting a semiconductor wafer 1 (hereinafter referred to as "wafer") as an object to be processed. A dielectric member 180 of the embodiment is arranged on the susceptor 153. Other detailed structure is described below. Herein, the dielectric member 180 is supported by three (only one is shown in Fig. 1) shafts 200.

The supporting member 154 has a substantially cylindrical shape and supports the susceptor 153. A heater 156 is embedded in the susceptor 153 in order to heat the wafer 1. A electric power source 175 supplies electric power to the heater 156 via an electric-power connecting line 177.

A coil 157 is wound around the bell jar 152 as an antenna member. A high-frequency electric power 158 is connected to the coil 157 via a matching unit 159. The high-frequency electric power 158 can generate a high-frequency electric power having a frequency of for example 450 kHz to 60 MHz, preferably 450 kHz to 13.56 MHz.

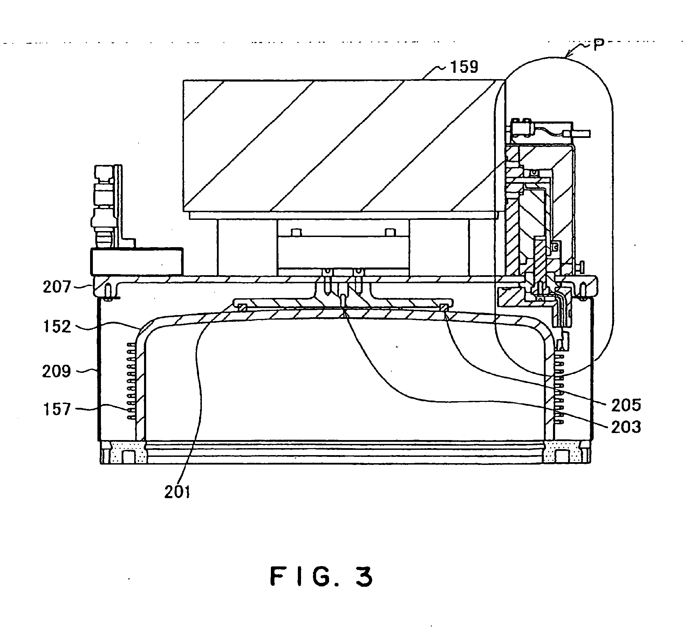

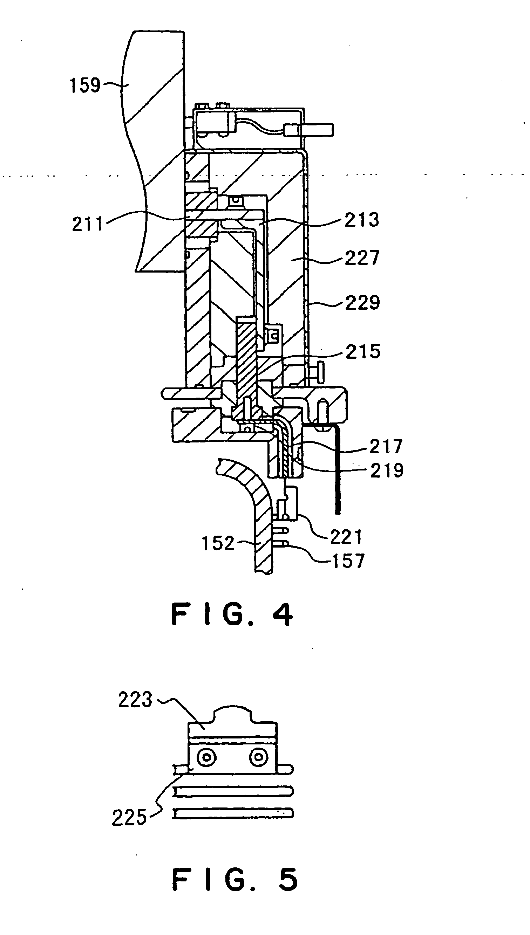

Herein, a structure of an upper portion of the bell jar 152 is explained. Fig. 3 is a schematic sectional view showing a structure of the upper portion of the bell jar 152. Fig. 4 is an enlarged view of P portion of Fig. 3. As shown in Fig. 3, An opposite electrode 201, which is opposite to the electrode 153, is provided above the outside of the bell jar 152. The opposite electrode 201 is made of Al or the like. The opposite electrode 201 is provided on the bell jar 152 via a cap 203 and a spacer ring 205, which are arranged in a central portion thereof in order to prevent interference with the bell jar 152. The cap 203 and the spacer ring 205 are made of resin such as Teflon, and press down the bell jar 152 hermetically.

The opposite electrode 201 is connected to a cover 207 made of Al, which is arranged above the opposite electrode 201. The cover 207 is connected to a sheath cover 209 surrounding a lateral surface of the bell jar 152 and made of Al. The opposite electrode 201 is grounded via the cover 207 and the sheath cover 209.

The matching unit 159 is arranged above the cover 207 and electrically connected to the coil 157 via the P portion of Fig. 3. As shown in Fig. 4, the P portion includes: an electrode 211 connected to the matching unit 159; an electrode 213 connected to the electrode 211; an electrode 215 connected to the electrode 213; and an electrode 217 connected to the electrode 215 by means of screws 219. Each electrode is detachable. The electrode 217 is connected to a clip 221. The clip 221 holds the coil 157 so that the matching unit 159 and the coil 157 are electrically connected to each other.

The clip 221 has a function to electrically connect the electrode 217 with the coil 157. For example, as shown in Fig. 5, a connecting part 233 electrically connected to the electrode 217 is connected to the coil 157 by means of screws 225. The electrodes 213 and 215 may be copper coated with silver. A cover 227 made of heat-resistant resin such as amide resin covers the outside of the electrodes 213 and 215. The cover 227 is covered with another cover 229 made of Al. As described above, a high-frequency electric power is supplied from the high-frequency electric power source 158 to the coil 157 via the matching unit 159, so that an induction field is formed in the bell jar 152.

A gas supplying mechanism 160 includes an Ar supplying source 161 that supplies Ar for etching a surface of a semiconductor wafer and an H₂ supplying source 162 that supplies H₂ for reducing an oxide of a metal material. Gas lines 163 and 164 are respectively connected to the gas supplying sources 161 and 162. Valves 165 and 178 and a mass-flow controller 166 are provided in each line.

A gas-introducing ring 167 is provided between the bell jar 152 and a ceiling part of a lateral wall of the chamber 151. A plurality of gas-introducing holes 167a that can discharge a process gas in directions shown by arrows, that is, toward a central portion (point α) of a space 155 in the bell jar 152, are provided in an inside wall of the gas-introducing ring 167. The gas-introducing ring 167 is hermetically fixed on the upper part of the lateral wall of the chamber 151 via a seal by means of bolts or the like. Each gas-introducing hole 167a is arranged at such an angle that the process gas can be discharged toward the central portion (point α) of the space 155 at a half height of the number (height) of induction coils arranged outside the bell jar 152. In addition, the plurality of gas-introducing holes 167a is arranged at regular intervals. Thus, the process gas can be discharged uniformly in the space 155 of the bell jar 152.

The gas-introducing holes 167a are not limited to the above, but the number and/or the discharging angle can be adjusted to form a uniform gas flow depending on a size of the unit. In this embodiment, twenty gas-introducing holes 167a are formed. The discharging (uniform) angle is free depending on a molding angle. The discharging angle may be fixed to an angle toward a center position of the space 155, that is, toward a position above a semiconductor wafer.

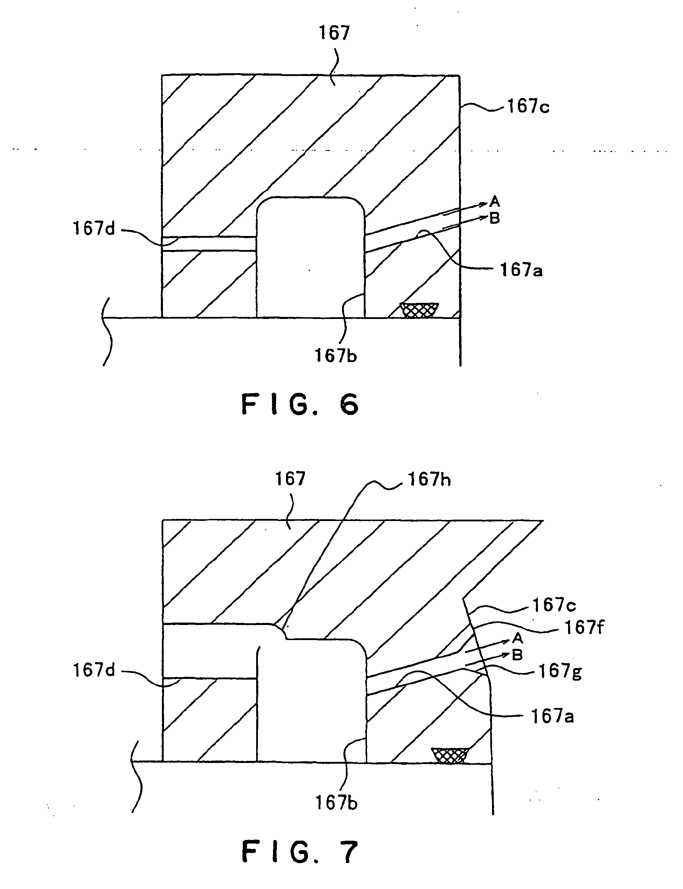

As shown in Fig. 6 as well, the gas-introducing ring 167 is provided with a circular groove 167b and a gas way 167d communicated with the groove 167b. The gas lines 163 and 164 are connected to the gas way 167d. The gases from the gas lines 163 and 164 are poured into the gas-introducing ring 167 via the gas way 167d, and then the etching gas is introduced (discharged out) to the central portion of the space 155 via the gas-introducing holes 167a. As shown in Fig. 6, a lateral surface 167c of the gas-introducting ring 167 on the side of the space 155 is formed to be vertical. Each gas-introducing hole 167a opens at the vertical lateral surface 167c. However, according to the above constitution, a gas flow A discharged from an upper portion of each hole and a gas flow B discharged from a lower portion of each hole may have different velocities. Thus, when the process gas is discharged our from the gas-introducing holes 167a, a turbulent flow (spiral flow) may be formed in a vicinity of an outlet of each gas-introducing hole 167a. Thus, the gas can not be introduced uniformly into the space 155. Then, as shown in Fig. 7, a tapered surface 167f is formed in the lateral surface 167c of the gas-introducing ring 167 on the side of the space 155. Upwardly formed gas-introducing holes 167a open substantially perpendicular to the tapered surface 167f. In addition, the gas-introducing holes 167a are formed in such a manner that directions of the gas-introducing holes 167a cross each other at the half height of the number (height) of induction coils. Thus, the velocity difference between a gas flow A discharged from an upper portion of each hole and a gas flow B jetted from a lower portion of each hole may be reduced, so that the gas can be introduced uniformly into the chamber. A portion near to an outlet of each gas-introducing hole 167a on the side of the space 155 may be edge-chamfered to form an outlet 167g that is wider than the gas-introducing hole as shown in Fig. 7. In the case, gas discharging resistance may be reduced.

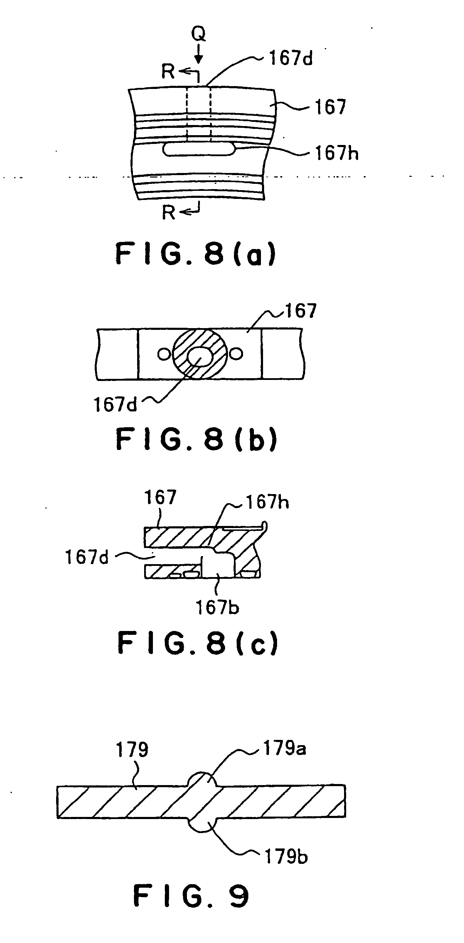

Next, with reference to Fig. 8, a constitution of the gas passage 167d for introducing the gas into the groove 167b of the gas-introducing ring 167 is explained. Fig. 8 is a view showing a constitution of the gas passage 167d. Fig. 8 (a) is a schematic top view, Fig. 8 (b) is a schematic view seen in Q direction, and Fig. 8 (c) is a schematic sectional view taken along R-R line.

As shown in Fig. 8, the gas-introducing ring 167 is provided with the gas way 167d for introducing the gas into the inside groove 167b. As shown in Fig. 8(b), an inlet of the gas passage 167d is exposed at the outside of the gas-introducing ring 167. As shown in Figs. 8 (a) and 8(c), a lateral hole 167h is provided at an upper portion of a connecting part between the gas passage 167d and the groove 167b. In addition, a partition is provided on the side of the groove 167b of the connecting part between the gas passage 167d and the groove 167b. Thus, the gas introduced from the gas passage 167d is adapted to be introduced into the groove 167b via the lateral hole 167h. According to the above constitution, the gas is apt to flow in a circumferential direction (width direction) of the groove 167b. Thus, the gas can be discharged more uniformly toward the space 155.

In addition, the lateral wall of the chamber 151 and the lateral wall of the bell jar 152 are airtightly connected via the gasket 179 in order to maintain a vacuum level. Fig. 9 is a sectional view of the gasket 179 according to the embodiment. The gasket 179 shown in Fig. 9 is interposed between a sealing surface of the bell jar 152 and a sealing surface of the gas-introducing ring 167. Thus, airtightness can be maintained, and the sealing surface of the bell jar 152 can be protected against breakdown. Herein, in order to more improve the performance of maintaining the airtightness, the gasket 179 may be made of a fluorine-series elastomer material, for example. In addition, preferably, as shown in Fig. 9, semicircular protrusions or convex protrusions 179a, 179b may be formed on an upper surface and a lower surface of the circular gasket. Of course, the protrusion 179a on the lower surface of the gasket 179 is unnecessary. In addition, a plurality of, for example two, protrusions 179a may be formed on the upper surface of the gasket 179.

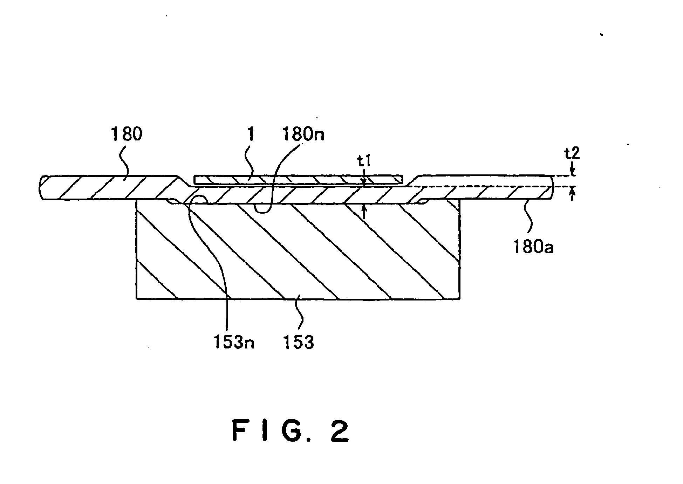

Fig. 2 is a schematic sectional view showing a semiconductor-wafer placing portion 100 according to the embodiment shown in Fig. 1. As shown in Fig. 2, the seiniconductor-wafer placing portion 100 includes the susceptor 153 and the dielectric member 180.

The susceptor 153 is made of AlN. The dielectric member 180 is made of SiO₂, which is material capable of maintaining dielectric property during a plasma process. Then, the dielectric member 180 is adapted to be placed on the susceptor 153. The dielectric member 180 of the embodiment is made of quartz.

A step t2 that is downwardly concave is formed on an upper surface of a central portion of the dielectric member 180. That is, an upper surface of an outer peripheral portion of the dielectric member 180 protuberates higher than the upper surface of the central portion by the step t2. An outer periphery of the wafer 1 is guided by the step t2. Thus, the wafer 1 may be placed at a precise position. If a thickness of the wafer 1 is about 0.7 mm, the step t2 is, for example, about 0.5 to 3 mm, preferably 0.5 to 1 mm, more preferably the same thickness level as the wafer thickness level.

An outer diameter of the dielectric member 180 is formed to be larger than an outer diameter of the susceptor 153. That is, an outer-peripheral portion 180a is provided, which outwardly overreaches the susceptor 153 when the dielectric member 180 is placed on the susceptor 153. In addition, a convex portion 180n that is downwardly convex is formed on a lower surface of a central portion of the dielectric member 180. The convex portion 180n is contained in a concave portion 153n, which is upwardly concave, provided on an upper surface of the susceptor 153.

Concretely, for example, the concave portion 153n of the susceptor 153 may be formed as a counter boring as shown in Fig. 2. Then, the convex portion 180n of the dielectric member 180 may be adapted to come in contact with the concave portion 153n of the susceptor 153, and a lower surface of the outer-peripheral portion 180a of the dielectric member 180 may be adapted to come in contact with an upper surface of an edge portion (outer peripheral portion) of the susceptor 153. At that time, the dielectric member 180 may continue to be stably placed on the susceptor 153, without falling down from the susceptor 153.

If a thickness t1 of a central portion of the dielectric member 180 is too thin, it is difficult to conduct a processing (manufacturing) operation thereof, and durability thereof is inferior. On the other hand, if the thickness t1 is thicker, it needs more cost. Thus, the thickness t1 is 0.5 to 5 mm, preferably 0.5 to 1 mm.

As shown in Fig. 1, a gas-discharging unit 169 including a vacuum pump is connected to an exhausting pipe 168. A portion of a bottom wall of the chamber 151 is open, and the opening portion is hermetically connected to a concave exhausting part 182. The exhausting pipe 168 is connected to a lateral opening portion of the exhausting part 182. A supporting member 154 that supports the susceptor 153 is provided at a bottom of the exhausting part 182. Then, the exhausting unit 169 can be driven to reduce a pressure in the chamber 151 and the bell jar 152 to a predetermined vacuum level via the gas-discharging part 182 and the exhausting pipe 168.

A gate valve 170 is provided at the lateral wall of the chamber 151. A wafer 1 can be conveyed from or to an adjacent load-lock chamber (not shown) while the gate valve 170 is opened. An electrode 173 embedded in the susceptor 153 is connected to a high-frequency electric power source 171 via a matching unit 172. Thus, a bias application to the electrode 173 is possible.

An operation of the above plasma processing unit is explained. At first, the gate valve 170 is opened, and the wafer 1 is inserted into the chamber 151. Then, lifter pins 181a are raised by a lifter-pin elevating part 181b included in a lifter-pin driving mechanism 181, so that the lifter pins 181a receive the wafer 1. Then, the lifter pins 181a are lowered, so that the wafer 1 is placed on the placement surface of the dielectric member on the susceptor 153. Then, the gate valve 170 is closed, and the gas in the chamber 151 and the bell jar 152 is discharged to a predetermined reduced-pressure condition by means of the exhausting unit 169. Next, the Ar gas and the H₂ gas are supplied from the Ar gas supplying source 161 and the H₂ gas supplying source 162 into the chamber 151. At the same time, a high-frequency electric power is supplied from the high-frequency electric power 158 to the coil 157, so that an induction field is formed in the space 155 of the bell jar 152.

By means of the induction field, a plasma is generated in the space 155 of the bell jar 152. Then, by means of the plasma, a film of a surface of the wafer 1, such as an oxide film, is etched and removed. At that time, a bias voltage can be applied to the susceptor 153 from the high-frequency electric power source 171. If necessary, for example if a process gas using an H₂ gas or the like is used, electric power can be supplied from the electric power source 175 to the heater 156 in order to heat the susceptor 153.

As an example of a process condition, a pressure is 0.1 to 13.3 Pa, preferably 0.1 to 2.7 Pa, a wafer temperature is 100 to 500 °C, a flow rate of the Ar gas is 0.01 to 0.03 L/min, preferably 0.005 to 0.015 L/min, a flow rate of the H₂ gas is 0 to 0.06 L/min, preferably 0 to 0.03 L/min, a frequency of the high-frequency electric power source 158 is 450 kHz to 60 MHz, preferably 480 kHz to 13.56 MHz, and a bias voltage is -20 to -200 V (0 to 500 W). When an etching process was conducted for about 30 seconds by using a plasma of such a condition, an SiO₂ film as an oxide film was removed by about 1 to 10 nm.

In the plasma processing unit 150 having the semiconductor-wafer placing portion 100, conventionally, a plasma process using dummy wafers has been conducted in order to initialize the unit against memory effect or to prevent generation of particles. Instead, according to the embodiment, for example while the wafer 1 is conveyed in or order to initialize the unit against memory effect or to prevent generation of particles. Instead, according to the embodiment, for example while the wafer 1 is conveyed in or out, an etching process to the dielectric member 180 is conducted under a condition wherein the wafer 1 is not placed thereon. This is referred to as an after-process process.

As an actual process condition, an output of the high-frequency electric power source 158 for ICP is 200 to 1000 W (preferably 200 to 700 W), an output of the electric power source 171 for the bias voltage is 100 to 500 W (preferably 400 W) at a frequency of 13.56 MHz, a pressure is about 0.1 to 1.33 Pa (preferably 0.67 Pa), and it is preferable to use only the Ar gas. An flow rate of the Ar gas is 0.001 to 0.06 L/min (preferably 0.001 to 0.03 L/min, or 0.038 L/min) , and a susceptor temperature is -20 to 500 °C, preferably 200 °C (the susceptor temperature is preferably 500 °C when a mixture gas of the Ar gas and the H₂ gas is used). In addition, a processing time is 5 to 30 sec, preferably for example about 10 sec. When the dielectric member is etched under the process condition, dielectric substances are deposited on the wall of the bell jar. Thus, memory effect and generation of particles may be prevented.

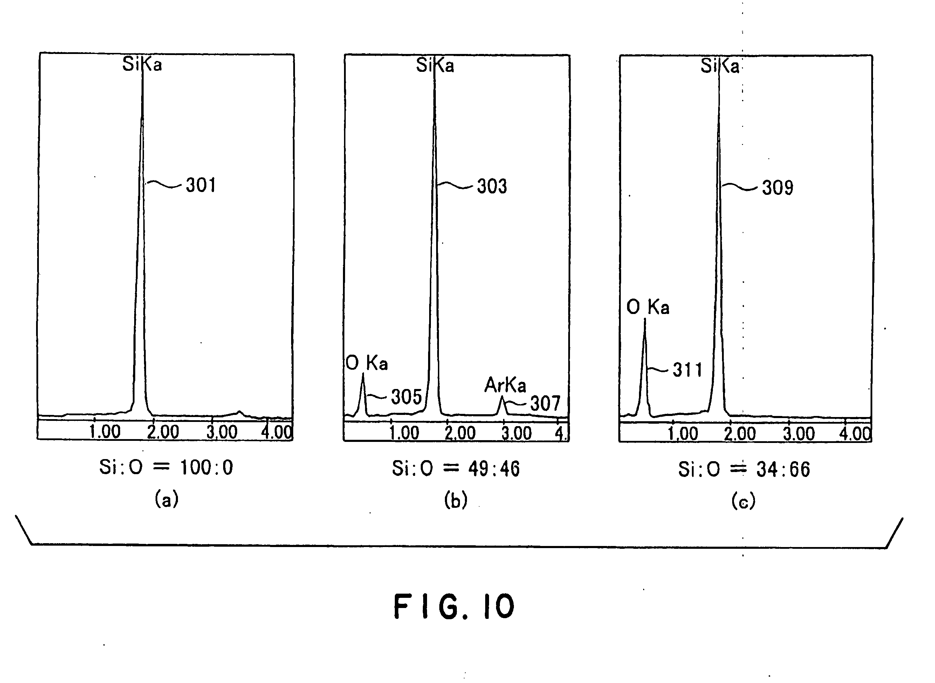

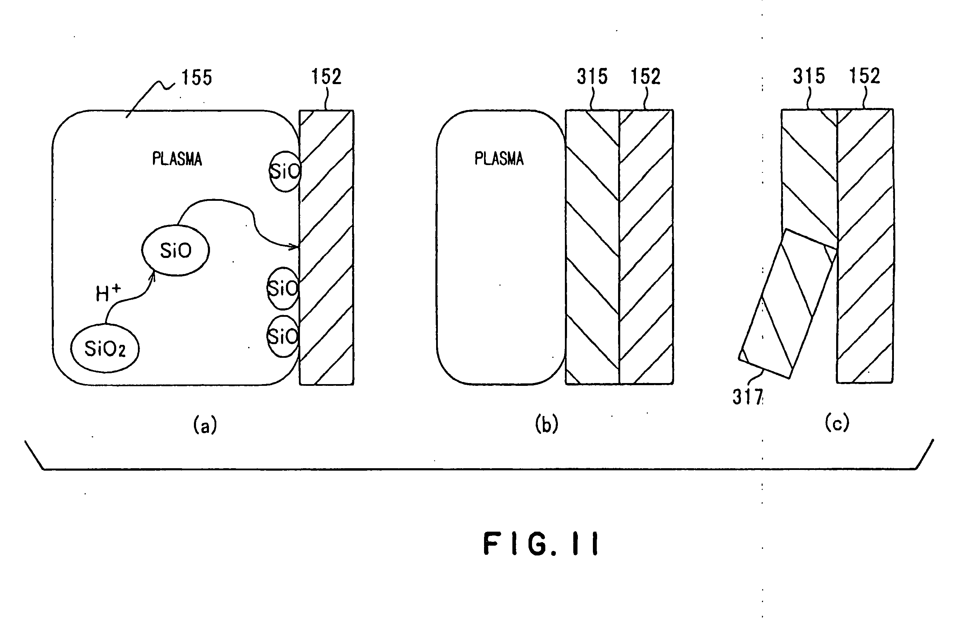

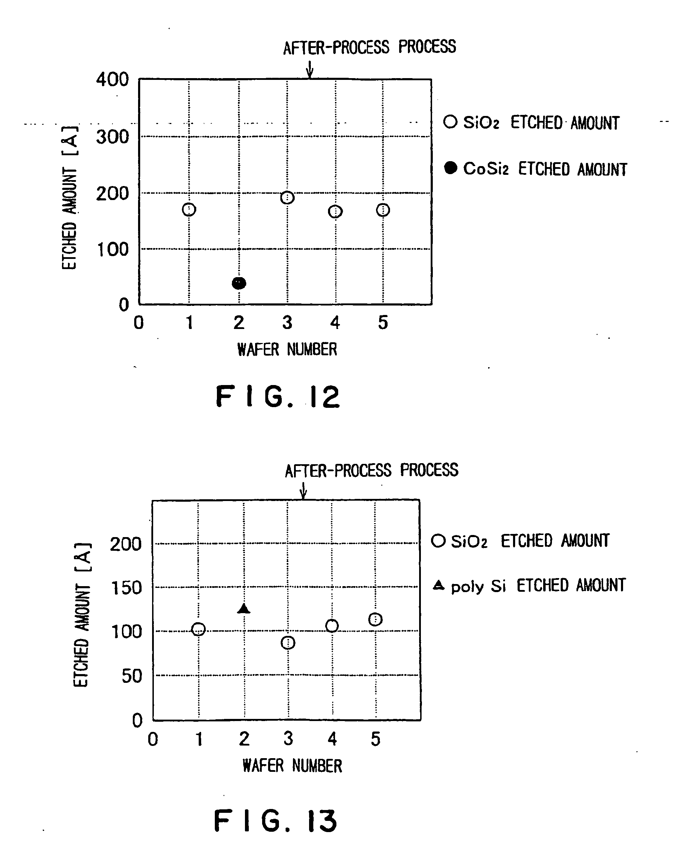

Herein, mechanism of the generation of particles and the memory effect are explained with reference to Figs. 10, 11, 12 and 13. Fig. 10 is an abundance analysis chart by means of SEM-EDX (Scanning Electron Microscope with Energy Dispersive type of X-ray spectroscope), Fig. 11 is a conceptual view of the generation of particles, Figs. 12 and 13 are graphs showing changes of etched amount caused by memory effect.

Figs. 10 (a), 10 (b) and 10 (c) are abundance analysis charts of Si, substances deposited on the lateral wall of the bell jar 152 and SiO₂, respectively. As shown in Fig. 10, ratios of Si element: O₂ element detected from the Si, the substances deposited on the lateral wall of the bell jar 152 and the SiO₂, are 100:0, 49:46 and 34:66, respectively. Thus, it may be estimated that the substances deposited on the lateral wall of the bell jar 152 are SiO including Si element and **O** element of about 1:1.

As shown in Fig. 11(a), if there is etched SiO₂ in the space 155 of the bell jar 152, it is thought that the SiO₂ is reduced to SiO by H⁺ dissociated from the H₂ gas in the process gas by the plasma, and then deposited on the lateral wall of the bell jar 152.

As shown in Fig. 11(b), after a process of many wafers is conducted, an amount of the deposited SiO is large, so that the deposited SiO becomes a film-like deposit 315. If a thickness of the Si-rich SiO film exceeds a certain degree, it may peel off down like a deposit 317 shown in Fig. 11 (c) by means of stress. This may generate particles. Thus, as described above, the after-process process for inhibiting the generation of particles is preferably conducted only by the Ar gas which doesn't reduce SiO₂.

In addition, Figs. 12 and 13 show etched amounts under the same etching condition. As shown in Figs. 12 and 13, when SiO₂ of a first semiconductor wafer is etched, CoSi₂ and/or Poly-Si of a second semiconductor wafer is etched, and then SiO₂ of a third semiconductor wafer is etched, an etched amount of the third semiconductor wafer may be different from an etched amount of the first semiconductor wafer (memory effect).

If a substance to be etched is changed, a substance to be deposited on the inner wall of the chamber is also changed. This makes the generated plasma unstable. It is thought that the memory effect is generated thereby.

If the memory effect occurs, the above after-process process is conducted before the next process (herein, an etching process for a fourth semiconductor wafer). Thus, as shown in Figs. 2 and 13, the etched amount before etching CoSi₂ and/or Poly-Si may be recovered. The reason is thought that the inner wall of the chamber is covered with the original substances again and thus the plasma condition is made stable again. That is, the after-process process has an effect to dissolve the memory effect.

In addition, when the dielectric member 180 is processed under the above condition in order to carry out the after-process process, the following result is obtained about a plasma processing time necessary to recover an etching rate of a stationary state.

The process has to continue for about 150 seconds for measures against the memory effect after etching a conductive material other than an oxide film, such as Poly-Si (Poly-Silicon) or CoSi₂ (Cobalt Silicon, Cobalt Silicide), for about 300 seconds for initialization after a wet-cleaning conducted by using a chemical or the like at maintenance in the chamber, and for 1500 seconds for preventing the particles. However, according to the embodiment, the inside of the chamber can be returned to the stationary state by etching the dielectric member only for some decade seconds, so that an optimum etching process is possible.

Especially, when an etching process of a silicon oxide film is repeatedly conducted by plasma of a mixture gas of the Ar gas and the H₂ gas used as a process gas, spattered SiOₓ is deposited on an inside wall of a processing container or on a surface of a member in the processing container. Then, when H⁺ and H* are dissociated from the H₂ gas being the process gas by the plasma, the SiOₓ is corroded by these so that particles are generated. Thus, if the dielectric member 180 made of SiO₂ or the like, for example, is plasma-processed to cover the inside wall of a processing container and/or the surface of a member in the processing container with a new dielectric film such as SiO₂ or the like, the inside wall and/or the surface becomes a state difficult to generate particles, so that the generation of particles are inhibited. It is preferable to use the Ar gas as a process gas for the plasma process to prevent the generation of particles.

If dummy wafers, each of which needs 30 to 60 seconds to be processed, are used for the process, the measures against the memory effect corresponds to 5 or more dummy wafers, the initialization after a wet-cleaning conducted by using a medicine or the like corresponds to 10 or more dummy wafers, and the prevention of the particles corresponds to 50 or more dummy wafers. According to the embodiment that processes the dielectric member 180 as described above, it is unnecessary to prepare any dummy wafer for the measures against the memory effect, for the initialization after a wet-cleaning conducted by using a chemical or the like, and for the prevention of the particles. Thus, efficiency of operations and production may be improved. In addition, the dielectric member 180 can be easily replaced when it wears out after the etching processes.

### (Second Example Helpful for Understanding the Present Invention)

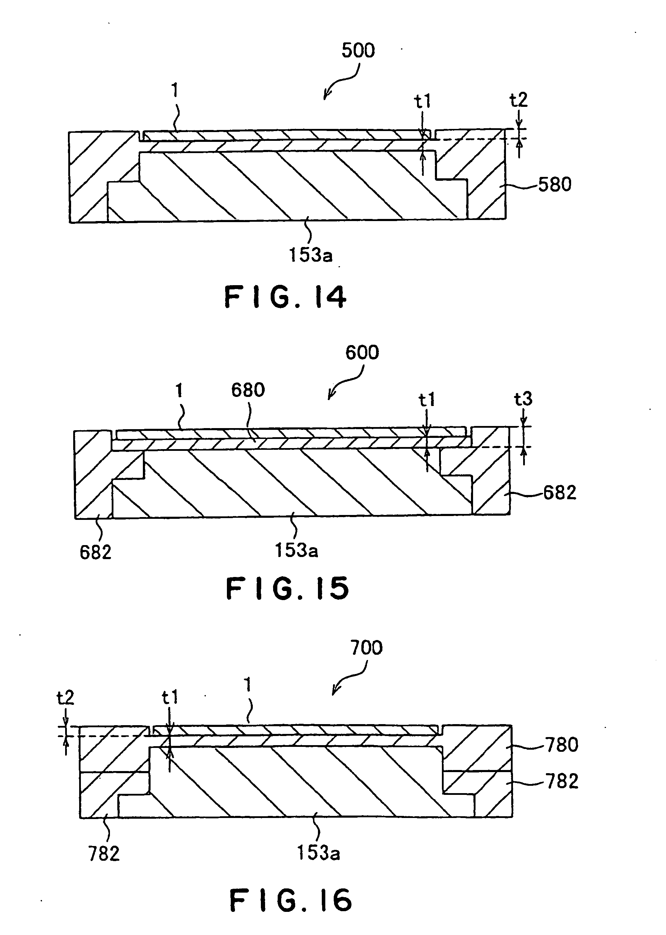

Fig. 14 is a schematic sectional view showing a semiconductor-wafer placing portion 500 according to a second example helpful for understanding the present invention. As shown in Fig. 14, the semiconductor-wafer placing portion 500 may be used in the plasma processing unit 150, instead of the semiconductor-wafer placing portion 100. The same constitutions and functions as the preferred embodiment are given the same signs, and explanation thereof is omitted.

A susceptor 153a has a convex part in a central portion thereof, and is made of for example, AlN or the like. A dielectric member 580 is made of for example SiO₂, Al₂O₃. AlN, Si₃N₄ or the like which are material capable of maintaining dielectric property during a plasma process. The dielectric member 580 has a shape of covering the whole susceptor 153a.

If a thickness t1 of a central portion of the dielectric member 580 is too thin, it is difficult to conduct a processing operation thereof, and durability thereof is inferior. On the other hand, if the thickness t1 is thicker, it needs more cost. Thus, the thickness t1 is, for example about 0.5 to 5 mm, preferably 0.5 to 1 mm.

A step t2 that is downwardly concave is formed on an upper surface of a central portion of the dielectric member 580. That is, an upper surface of an outer peripheral portion of the dielectric member 580 protuberates higher than the upper surface of the central portion by the step t2. An outer periphery of the wafer I is guided by the step t2. Thus, the wafer 1 may be placed at a precise position. If a thickness of the wafer I is about 0.7 mm, the step t2 is, for example, about 0.5 to 3 mm, preferably 0.5 to 1 mm, more preferably the same thickness level as the wafer thickness level.

In the plasma processing unit 150 having the semiconductor-wafer placing portion 500, for the measures against the memory effect, for the initialization after the wet cleaning process, or for preventing the generation of particles, the dielectric member 580 is etched without placing the wafer 1 thereon, instead of the conventional process conducted by using dummy wafers.

An etching condition, a required time or the like are substantially the same as the preferred embodiment. However, the dielectric member 580 may be more easily fixed to the susceptor 153a, which makes it possible to adopt a constitution wherein the dielectric member 580 is not supported by shafts. At a plasma process to prevent the generation of particles, it is preferable to use only the Ar gas as a process gas.

### (Third Example Helpful for Understanding the Present Invention)

Fig. 15 is a schematic sectional view showing a semiconductor-wafer placing portion 600 according to a third example helpful for understanding the present invention. As shown in Fig. 15, the semiconductor-wafer placing portion 600 may be used in the plasma processing unit 150, instead of the semiconductor-wafer placing portion 100. The same constitutions and functions as the preferred embodiment and second example helpful for understanding the present invention are given the same signs, and explanation thereof is omitted.

The semiconductor-wafer placing portion 600 includes the susceptor 153a and dielectric members 680 and 682. The dielectric members 680 and 682 are made of for example, SiO₂, Al₂O₃, AlN, Si₃N₄ or the like, which are materials capable of maintaining dielectric property during a plasma process. The dielectric members 680 and 682 have a shape of covering the whole susceptor 153a.

If a thickness t1 of a central portion of the dielectric member 680 is too thin, it is difficult to conduct a processing operation thereof, and durability thereof is inferior. On the other hand, if the thickness t1 is thicker, it needs more cost. Thus, the thickness t1 is, for example about 0.5 to 5 mm, preferably 0.5 to 1 mm.

A step t3 that is downwardly concave is formed on an upper surface of the dielectric member 682. That is, an upper surface of an outer peripheral portion of the dielectric member 682 protuberates higher than the upper surface of the central portion by the step t3. Outer peripheries of the dielectric member 680 and the wafer 1 are guided by the step t3. Thus, the wafer 1 may be placed at a precise position. If a thickness of the wafer 1 is about 0.7 mm, the step t3 is, for example, about 0.5 to 3 mm, preferably 0.5 to 1 mm, more preferably the same thickness level as the wafer thickness level.

In the plasma processing unit 150 provided with the semiconductor-wafer placing portion 600, for the measures against the memory effect, for the initialization after the wet cleaning process, or for preventing the generation of particles, the dielectric member 680 is etched without placing the wafer 1 thereon, instead of the conventional process conducted by using dummy wafers.

An etching condition, a required time or the like are substantially the same as the preferred embodiment and second example helpful for understanding the present invention.

However, since the two dielectric members are assembled, a processing operation at manufacture thereof is easier compared with the single dielectric member 580. In addition, the replacement is also much easier when they wear out after the etching processes. At a plasma process to prevent the generation of particles, it is preferable to use only the Ar gas as a process gas.

### (Fourth Example Helpful for Understanding the Present Invention)

Fig. 16 is a schematic sectional view showing a semiconductor-wafer placing portion 700 according to a fourth example helpful for understanding the present invention. As shown in Fig. 16, the semiconductor-wafer placing portion 700 may be used in the plasma processing unit 150, instead of the semiconductor-wafer placing portion 100. The same constitutions and functions as the preferred embodiment and second and third examples helpful for understanding the present invention are given the same signs, and explanation thereof is omitted.

The semiconductor-wafer placing portion 700 includes the susceptor 153a and dielectric members 780 and 782. The dielectric members 780 and 782 are made of, for example, SiO₂, Al₂O₃, AlN, Si₃N₄ or the like, which are materials capable of maintaining dielectric property during a plasma process. The dielectric members 680 and 682 have a shape of covering the whole susceptor 153a.

If a thickness t1 of a central portion of the dielectric member 780 is too thin, it is difficult to conduct a processing operation thereof, and durability thereof is inferior. On the other hand, if the thickness t1 is thicker, it needs more cost. Thus, the thickness t1 is, for example about 0.5 to 5 mm, preferably 0.5 to 1 mm.

A step t2 that is downwardly concave is formed on an upper surface of a central portion of the dielectric member 780. That is, an upper surface of an outer peripheral- portion of the dielectric member 780 protuberates higher than the upper surface of the central portion by the step t2. An outer periphery of the wafer 1 is guided by the step t2.

Thus, the wafer 1 may be placed at a precise position. If a thickness of the wafer 1 is about 0.7 mm, the step t2 is, for example, about 0.5 to 3 mm, preferably 0.5 to 1 mm, more preferably the same thickness level as the wafer thickness level.

In the plasma processing unit 150 provided with the semiconductor-wafer placing portion 700, for the measures against the memory effect, for the initialization after the wet process, or for preventing the generation of particles, the dielectric member 780 is etched without placing the wafer 1 thereon, instead of the conventional process conducted by using dummy wafers.

An etching condition, a required time or the like are substantially the same as the preferred embodiment and examples helpful for understanding the present invention. However, since the two dielectric members are assembled, compared with the single dielectric member 580, the replacement is easier when they wear out after the etching processes. In addition, compared with the dielectric members according to the second and third examples helpful for understanding the present invention, the same effect may be achieved by less amount of material. At a plasma process to prevent the generation of particles, it is preferable to use only the Ar gas as a process gas.

### Fifth Example Helpful for Understanding the Present Invention)

Fig. 17 is a schematic sectional view showing a semiconductor-wafer placing portion 800 according to a fifth example helpful for understanding the present invention. As shown in Fig. 17, the semiconductor-wafer placing portion 800 may be used in the plasma processing unit 150, instead of the semiconductor-wafer placing portion 100. The same constitutions and functions as the preferred embodiment and the second, third and fourth examples helpful for understanding the present invention are given the same signs, and explanation thereof is omitted.

The semiconductor-wafer placing portion 800 includes the susceptor 153 and a dielectric member 880. The dielectric member 880 is made of for example SiO₂ Al₂O₃, AlN Si₃N₄ or the like which are materials capable of maintaining dielectric property during a plasma process. The dielectric member 880 has a shape of covering the whole susceptor 153. An upper portion of the susceptor 153 has a shape coinciding with the shape of the dielectric member 880, and thus is different from the susceptor 153a.

If a thickness t1 of a central portion of the dielectric member 880 is too thin, it is difficult to conduct a processing operation thereof, and durability thereof is inferior. On the other hand, if the thickness t1 is thicker, it needs more cost. Thus, the thickness t1 is, for example about 0.5 to 5 mm, preferably 0.5 to 1 mm.

A step t2 that is downwardly concave is formed on an upper surface of a central portion of the dielectric member 880. That is, an upper surface of an outer peripheral portion of the dielectric member 880 protuberates higher than the upper surface of the central portion by the step t2. An outer periphery of the wafer 1 is guided by the step t2. Thus, the wafer 1 may be placed at a precise position. If a thickness of the wafer 1 is about 0.7 mm, the step t2 is, for example, about 0.5 to 3 mm, preferably 0.5 to 1 mm, more preferably the same thickness level as the wafer thickness level.

In the plasma processing unit 150 provided with the semiconductor-wafer placing portion 800, for the measures against the memory effect, for the initialization after the wet process, or for preventing the generation of particles, the dielectric member 880 is etched without placing the wafer 1 thereon, instead of the conventional process conducted by using dummy wafers.

An etching condition, a required time or the like are substantially the same as the first embodiment. However, since the shape of the dielectric member is simpler compared with the dielectric members of the first embodiment and the second, third and fourth examples helpful for understanding the present invention, the replacement is easier when it wears out after the etching processes. In addition, the same effect as the first embodiment may be achieved by less amount of material, which is preferable for a plasma processing unit that carries out mass production of a semiconductor device. At a plasma process to prevent the generation of particles, it is preferable to use only the Ar gas as a process gas.

The plasma processing unit according to the present invention and the preferable embodiments of initializing step thereof are explained with reference to the attached drawings. However, this invention is not limited to the embodiments. One of ordinary skill in the art can create various changed or modified examples within the scope of concept defined by the attached claims. The changed or modified examples are also included in the scope of the present invention.

For example, the shape and the material of the dielectric member are not limited to the above embodiments. If the same effect is achieved, any other shape and material may be adopted. In addition, a processing condition, a processing time or the like is specific to each plasma processing unit, but doesn't limit the invention.

## Claims

1. A plasma processing unit (150) comprising:
a processing chamber (151) having a dielectric wall (152),
a stage (153) provided in the processing chamber (151),
a quartz member (180) arranged to cover an upper surface of the stage (153) for receiving an object (1) to be processed thereon, and
an antenna member (157) for generating a plasma in the processing chamber (151),
**characterized in that**
said stage (153) consists of AlN and comprises a heater (156) embedded into said stage (153) for heating the object (1) to be processed;
a concave portion (153n) is formed on an upper surface of a central portion of said stage (153);
a convex portion (180n) that is adapted to fit with the concave portion (153n) of the upper surface of the stage (153) is formed on a lower surface of a central portion of said quartz member (180); and
a concave portion is formed on an upper surface of said quartz member (180) to form a placement surface onto which the object (1) to be processed is placed,
wherein a thickness (t1) of a central portion of said quartz member (180) is 0.5 mm to 5 mm.

2. The plasma processing unit (150) according to claim 1, wherein
a guide ring for guiding the object (1) to be processed is formed around the placement surface.

3. The plasma processing unit (150) according to claim 2, wherein
a surface of the guide ring is formed in such a manner that the surface is located lower than a processed surface of the object (1) to be processed.

4. The plasma processing unit (150) according to any of claims 1 to 3, wherein
the quartz member (180) has a convex shape capable of covering the stage (153).

5. The plasma processing unit (150) according to any of claims 1 to 4, wherein
the quartz member (180) consists of a placement-surface portion and a guide-ring portion which are separable from each other.

6. The plasma processing unit (150) according to claim 1, wherein the dielectric wall (152) has a belt-jar shape.

7. The plasma processing unit (150) according to any of claims 1 and 3 to 5, wherein the quartz member (180) has an outer peripheral portion that outwardly overreaches the stage (153).

## Patentansprüche

1. Plasmabearbeitungseinheit (150) mit:
einer Bearbeitungskammer (151), die eine dielektrische Wand (152) aufweist,
einer in der Bearbeitungskammer (151) vorgesehenen Aufnahme (153),
einem Quarz-Bauteil (180), das zur Abdeckung einer Oberseite der Aufnahme (153) zum Aufnehmen eines darauf zu bearbeitenden Gegenstandes (1) angeordnet ist, und
einem Antennenbauteil (157) zum Erzeugen eines Plasmas in der Bearbeitungskammer (151),
**dadurch gekennzeichnet, dass**
die Aufnahme (153) aus AlN besteht und eine in die Aufnahme (153) eingebettete Heizeinrichtung (156) zum Beheizen des zu bearbeitenden Gegenstandes (1) aufweist;
an einer Oberseite eines mittleren Abschnitts der Aufnahme (153) ein konkaver Abschnitt (153n) ausgebildet ist;
an einer Unterseite eines mittleren Abschnitts des Quarz-Bauteils (180) ein konvexer Abschnitt (180n) ausgebildet ist, der dazu eingerichtet ist, in den konkaven Abschnitt (153n) an der Oberseite der Aufnahme (153) zu passen; und
an einer Oberseite des Quarz-Bauteils (180) ein konkaver Abschnitt ausgebildet ist, der eine Aufnahmefläche bildet, auf die das zu bearbeitende Objekt (1) gelegt wird,
wobei eine Dicke (t1) eines mittleren Abschnitts des Quarz-Bauteils (180) 0,5 mm bis 5 mm beträgt.

2. Plasmabearbeitungseinheit (150) nach Anspruch 1, wobei ein Führungsring zum Führen des zu bearbeitenden Gegenstands (1) um die Aufnahmefläche herum ausgebildet ist.

3. Plasmabearbeitungseinheit (150) nach Anspruch 2, wobei eine Oberfläche des Führungsrings derart ausgebildet ist, dass die Oberfläche niedriger liegt als eine bearbeitete Oberfläche des zu bearbeitenden Gegenstandes (1).

4. Plasmabearbeitungseinheit (150) nach einem der Ansprüche 1 bis 3, wobei das Quarzbauteil (180) eine konvexe Form hat, welche die Aufnahme (153) abdecken kann.

5. Plasmabearbeitungseinheit (150) nach einem der Ansprüche 1 bis 4, wobei das Quarzbauteil (180) aus einem Aufnahmeflächenteil und einem Führungsringteil besteht, die voneinander trennbar sind.

6. Plasmabearbeitungseinheit (150) nach Anspruch 1, wobei die dielektrische Wand (152) eine Glockenform hat.

7. Plasmabearbeitungseinheit (150) nach einem der Ansprüche 1 und 3 bis 5, wobei das Quarz-Bauteil (180) einen äußeren Umfangsteil hat, der über die Aufnahme (153) nach außen reicht.

## Revendications

1. Élément de traitement par plasma (150) comprenant :
une chambre de traitement (151) ayant une paroi diélectrique (152),
un étage (153) prévu dans la chambre de traitement (151),
un élément en quartz (180) disposé pour recouvrir une surface supérieure de l'étage (153) pour recevoir un objet (1) à traiter, et
un élément d'antenne (157) pour produire un plasma dans la chambre de traitement (151),
**caractérisé en ce que** :
l'étage (153) est en AlN et comprend un moyen de chauffage (156) logé dans l'étage (153) pour chauffer l'objet (1) à traiter ;
une partie concave (153n) est formée sur une surface supérieure d'une partie centrale de l'étage (153) ;
une partie convexe (180n) qui est adaptée à se monter sur la partie concave (153n) de la surface supérieure de l'étage (153) est formée sur une surface inférieure d'une partie centrale de l'élément en quartz (180) ; et
une partie concave est formée sur une surface supérieure de l'élément en quartz (180) pour former une surface de positionnement sur laquelle l'objet (1) à traiter est placé ;
dans lequel l'épaisseur (t1) d'une partie centrale de l'élément en quartz (180) est de 0,5 à 5 mm.

2. Élément de traitement par plasma (150) selon la revendication 1, dans lequel une bague de guidage pour guider l'objet (1) à traiter est formée autour de la surface de positionnement.

3. Élément de traitement par plasma (150) selon la revendication 2, dans lequel une surface de la bague de guidage est formée de telle sorte que la surface est disposée plus bas qu'une surface traitée de l'objet (1) à traiter.

4. Élément de traitement par plasma (150) selon l'une quelconque des revendications 1 à 3, dans lequel l'élément en quartz (180) a une forme convexe apte à recouvrir l'étage (153).

5. Élément de traitement par plasma (150) selon l'une quelconque des revendications 1 à 4, dans lequel l'élément en quartz (180) consiste en une partie de surface de positionnement et une partie de bague de guidage qui sont séparables l'un de l'autre.

6. Élément de traitement par plasma (150) selon la revendication 1, dans lequel la paroi diélectrique (152) a une forme de cloche.

7. Élément de traitement par plasma (150) selon l'une quelconque des revendications 1 et 3 à 5, dans lequel l'élément en quartz (180) a une partie de surface périphérique externe qui recouvre l'étage (153) vers l'extérieur.
